Europäisches Patentamt

European Patent Office

Office européen des brevets

(11) Publication number: **0 129 137**
**B1**

(12) **EUROPEAN PATENT SPECIFICATION**

(45) Date of publication of patent specification: **25.01.89**

(21) Application number: **84106380.3**

(22) Date of filing: **05.06.84**

(51) Int. Cl.⁴: **H 05 K 3/32,** H 01 R 43/00,
H 01 R 23/68, H 05 K 3/42,
H 01 L 23/52

(54) Method of forming an aperture in a dielectric substance and securing a conductive pin in said aperture.

(30) Priority: **20.06.83 US 506071**

(43) Date of publication of application:
**27.12.84 Bulletin 84/52**

(45) Publication of the grant of the patent:
**25.01.89 Bulletin 89/04**

(84) Designated Contracting States:
**DE FR GB**

(56) References cited:
EP-A-0 074 303
DE-A-3 150 435
GB-A-1 021 320
US-A-4 193 082
US-A-4 202 007

(73) Proprietor: **International Business Machines
Corporation
Old Orchard Road
Armonk, N.Y. 10504 (US)**

(72) Inventor: **Dougherty, William Edwin, Jr.
34 LaGrange Avenue
Poughkeepsie New York 12603 (US)**
Inventor: **Greer, Stuart Eugene
Box 299A
Shelburne Vermont 05482 (US)**
Inventor: **Sargent, Robert Winston
Beaver Road
LaGrangeville New York 12540 (US)**

(74) Representative: **Neuland, Johannes, Dipl.-Ing.
IBM Deutschland GmbH Schönaicher Strasse
220
D-7030 Böblingen (DE)**

The file contains technical information
submitted after the application was filed and
not included in this specification

Courier Press, Leamington Spa, England.

## Description

This invention relates to a method of forming an aperture in a dielectric substrate and securing a conductive pin in said aperture.

In an effort to increase the density of circuits that can be placed on supporting substrates, multilayer dielectric substrates have been provided having embedded conductors that reach from one side of the substrate to the other. The manufacture of such substrate is described in the article "A Fabrication Technique for Multi-Layer Ceramic Modules" by H. D. Kaiser et al, in the journal "Solid State Technology", May 1972, pp. 35—40. U.S. Patent 4,193,082 and U.S. Patent 4,202,007 disclose multilayer dielectric substrates formed of a plurality of dielectric planar layers having a plurality of conductive leads coextensive with the planes of the layers and each having terminations at the edge surfaces of the layers. On these terminations there are input/output (I/O) metallization contact pins, or jacks, solder pads or other conductive materials. One proposed use for such a structure is to support integrated circuits disposed on one of the two major surfaces of the structure which are parallel to the planes of the layers, making electrical contact with the appropriate conductive leads and on the opposite surface to place I/O contact pins for connecting the conductive leads with external sources. In order to electrically connect the circuit from one surface of the structure to the opposite surface, these patents disclose the use of appropriate conductive via lines. Alternatively, via holes are suggested to be punched through the laminates prior to firing for the insertion of contact pins after firing.

The invention as claimed is intended to provide a method for forming an insulation structure having two major and opposite surfaces and conductor lines within the structure terminating in the two major surfaces and forming apertures in at least one major surface in which contact pins are securely anchored while making electrical contact with the adjacent conductor lines.

The advantages of this invention are accomplished by a method for forming an aperture in an insulating material which includes providing a material that has a coefficient of shrinkage responsive to a heat treatment that is different in one orthogonal direction from that in another direction and which will under a heat treatment irreversibly change dimensions in these directions in proportion to the differences in their respective coefficients of shrinkage. An aperture is then formed normal to the plane of the orthogonal directions, and a heat treatment is performed to thereby change the shape of the aperture. The insulating material used can be a unitized dielectric body formed from a plurality of dielectric planar layers having two major surfaces orthogonal to the directions of the dielectric planar layers. Such a material can be made to have two different coefficients of shrinkage for the two orthogonal directions in the plane of its major surfaces. When an aperture of a certain size is formed orthogonal to one of its major surfaces, then during the heat treatment the aperture will shrink by a different amount in its two directions and will change its shape. For example, if a round hole is machined in the insulating material prior to firing, then after firing the round hole will change to an elliptical form. A contact pin of a size that will permit it to fit into an aperture such as that formed in this material prior to the firing can be pressed and deformed to fit tightly and securely into the aperture that results following the firing of the dielectric body. The size of the pin is preselected so that after firing the pin will have one dimension which will be larger than one dimension of the aperture and another which will be smaller so that during the insertion the pin will be deformed and some of its material forced to extrude into the available space of the aperture. This will assure that the pin will be mechanically secured in the aperture. By providing the dielectric body with embedded conductor lines extending from one major surface of the material to the other and by forming the aperture and by placing its contact pins right on conductor lines assuring electrical contacts between portions of the conductor lines and the contact pins, electrical connections are established between its conductor termination on one major surface of the dielectric body and the contact pins on the opposite major surface. A similar result can be achieved by forming the aperture and the contact pins adjacent but not in direct contact with the conductor lines and then electrically connecting the pins and conductor lines with metal pads that surround the contact pins and cover the adjoining conductor line terminations. To further improve the reliability of the electrical connection, the pads can be plated with conventional techniques using conductive metallurgical materials, such as solder or braze.

The ways of carrying out the invention are described in detail below with reference to the drawings, of which

Fig. 1 illustrates a prior art multilayer dielectric structure.

Figs. 2a through 2b illustrate an aperture formed in accordance with the teachings of this invention before and after the heat treatment.

Figs. 3a through 3b illustrate an aperture with a contact pin inserted in it in accordance with the teachings of this invention.

Figs. 4a through 4c provide diagrammatic views of three embodiments made in accordance with the teachings of this invention.

Fig. 5 illustrates a conductive line adopted for use in an embodiment made in accordance with the teachings of this invention and shown in Fig. 6.

Fig. 6 provides a more detailed view of the embodiment made in accordance with the teachings of this invention.

Fig. 7 provides a more detailed view of the embodiment diagrammatically shown in Fig. 4c.

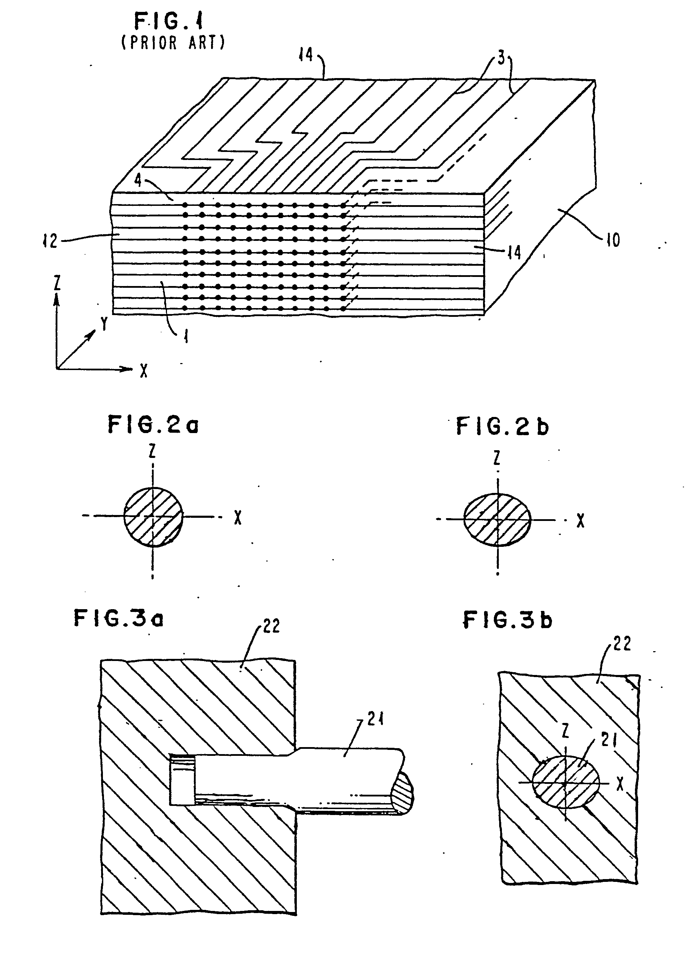

Referring now to Fig. 1, there is shown a multilevel dielectric structure constructed in accordance with the teachings of U.S. Patent 4,193,082. It is shown herein because the present invention can be practiced on a dielectric material such as that described in U.S. Patent 4,193,082 and illustrated herein as Fig. 1. The structure is made of a plurality of dielectric layers which are in turn made by the mixing of finely divided particles of glass, glass-ceramic or ceramic and other chemical additives such as organic solvents and binders which are then cast into slips, which upon evaporation of the solvent, form pliant green sheets. Until these sheets and the particulates within them are sintered together by a heat treatment (referred to as firing), they are termed green sheets. For the fabrication of multilayer green sheet structures, with a conductor pattern 3, the green sheets are coated with a conductive metal using the additive or subtractive processes as discussed in U.S. Patents 4,193,082 and 4,202,007. The green sheets are stacked or superimposed one on the other to form a multilayer dielectric structure having a plurality of dielectric sheets on an XY plane with the conductor lines and their terminations positioned to form the desired pattern. Thus the structure 10, shown in Fig. 1, consists of a plurality of dielectric layers 1, layed on an XY plane and stacked in an orthogonal Z direction. This structure has major surfaces 12 and 14 in the XZ plane and conductor lines 3 extending between surfaces 12 and 14 and having appropriate terminations 4 in both surfaces.

Referring now to Fig. 2a and 2b, there are shown two cross-sectional views of an aperture formed in accordance with the teaching of this invention to a structure such as that shown in Fig. 1 through its surface 14. In Fig. 2a there is shown a circular aperture formed in green sheets before they are placed in a sintering oven and exposed to a heat treatment, which is often referred to as firing. During this heat treatment the binder in the green sheets is driven off, normally by decomposition, followed by sintering or unification of the dielectric particles into a unitized structure. It has been discovered that during this firing, the green sheets shrink by a shrinkage factor that can be predetermined. The sheets shrink in both the X and Y direction by the same factor, which is typically 16 to 17%.

However in the Z direction the sheet shrinks by a greater factor. For example, for green sheets having a thickness of approximately 0.2 mm the shrinkage in the Z direction is about 20%. Thus, if a aperture such as that of Fig. 2a is formed by providing through surface 14 of Fig. 1 in the Y direction of the pressed but unsintered substrate 10, then the aperture will be circular in the XZ plane. After the heat treatment, the sheet will shrink by about 16% in X direction and by about 20% in the Z direction. Thus the circle of Fig. 2a will be transformed into an elipse as shown in Fig. 2b, with the two axes having a ratio of 4 to 5. The thicker the green sheets, the larger the differential will be for the shrinkage and the larger the ratio between the two axes of the elipse.

Referring now to Figs. 3a and 3b, there is shown a contact pin 21 partially deformed and anchored within a multilayer dielectric 22. The pin which was selected to be deformable was inserted in an aperture such as that of Fig. 2a formed in a body in accordance with the teachings of the present invention after the firing. A deformable pin can be made to deform and fit the elliptical aperture as shown in Fig. 3b. Fig. 3b shows a cross section of pin 21 locked into the dielectric body 22 along the XZ plane.

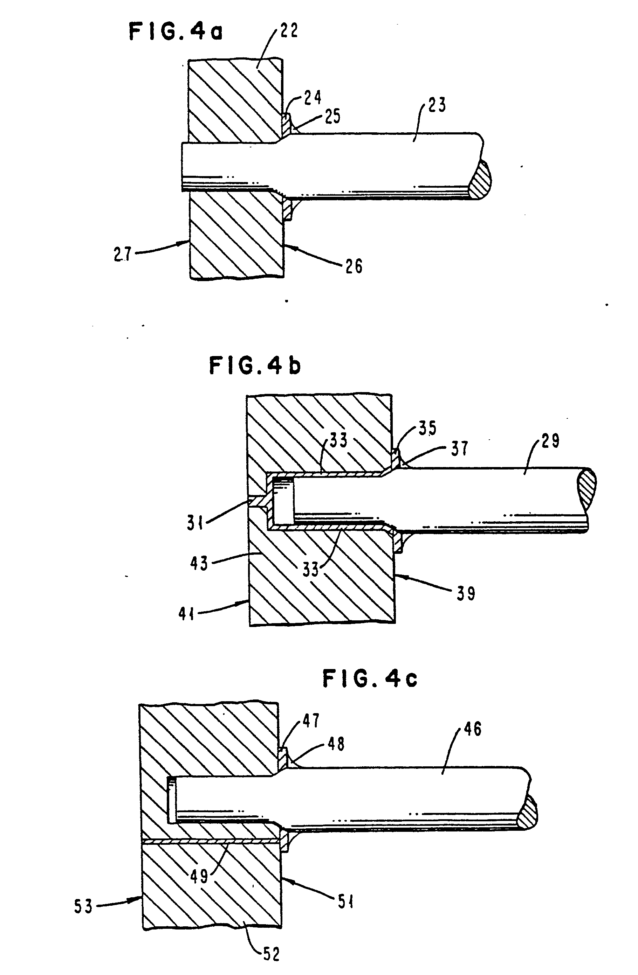

In Fig 4a there is shown an embodiment of this invention wherein a contact pin 23 is inserted through the entire depth of the dielectric body 22 (which is similar to body 10 of Fig. 1) making contact with both its major surfaces 26 and 27. There are also a pad 24 and a solder or braze fillet 25 to improve the electrical contact of pin 23 with conductive elements on surface 26. Pad 24 may be formed prior to firing and at the same time the conductor lines are formed. It can be formed from a similar material with the conductor lines, such as, for example from tungsten or molybdenum or copper. After firing the pads they may be coated with layers of Ni and Au to produce a solder wettable surface. The solder or braze fillet 25 is formed with conventional soldering or brazing techniques to assure a good electrical contact between the pin and the pad. In Fig. 4b there is shown another embodiment of this invention wherein a contact pin 29 does not go through the dielectric body 43 (which is similar to body 10 of Fig. 1) but it goes only part way. However pin 29 is anchored in an aperture that was formed on a conductor line that is flared close to surface 39 so that contact pin 29 can be in contact with portions 33 of the conductor line. A metal pad 35, which is formed with similar techniques as described for pad 24 of Fig. 4a, is also provided around pin 29 on surface 39. Solder or braze fillet material 37 is provided to improve the electrical contact between pin 29 and the metal pad 35 and conductor line portions 33. The remaining portion 31 of the conductor line completes the electrical connection between major surfaces 39 and 41. Portions 33 may be formed or reinforced through the use of a screened metal paste similar to the one used to make the other conductor lines and then joined by the metallurgical pad 35.

In Fig. 4c there is shown an alternative embodiment constructed in accordance with the teachings of this invention. Contact pin 46 does not go through the material and it does not contact directly conductor line 49. Conductor line 49 is however adjacent pin 46 and is electrically connected to pin 46 through metal pad 47 and solder fillet 48. Thus contact pin 46 is the electrical contact for conductor line 49 that extends between major surfaces 51 and 53.

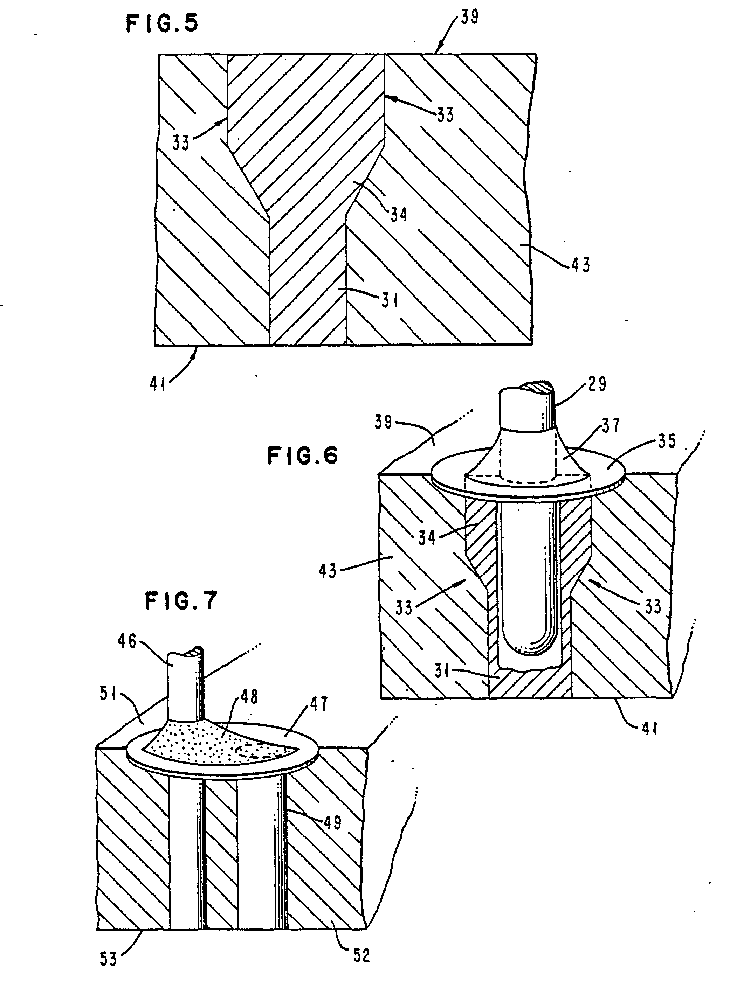

In Fig. 5 there is shown a conductor line 34 that has a narrow portion 31 and a flared portion 33. It extends between major surfaces 39 and 41 in the dielectric body 43, as shown in more detail in Fig. 6. Conductor line 34 can be formed by conventional conductor pattern forming techniques referred to in U.S. Patent 4,193,082. In Flg. 6 there is shown a more detailed view of an embodiment of this invention. As shown herein contact pin 29 is inserted in accordance with the teachings of the present invention in an aperture in dielectric body 43. The aperture is formed in a portion of body 43 that causes flared conductor 34, which has the form shown in Fig. 5, to split and terminate at surface 39 as two tabs 33, one on either side of the aperture. A metallurgical pad 35 intercepts tabs 33 at two places at which they are electrically connected. A plating of Ni/Au on all exposed conductor pads and tabs provides a wettable surface for the solder fillet to the contact pin 29.

In Fig. 7 there is shown a more detailed view of the embodiment shown in Fig. 4c. Pin 46 is not in direct contact with conductor line 49 but they are electrically connected together through pad 47 and solder fillet or braze 48. Thus together elements 46, 48, 47 and 49 form an electrically conducting path between major surfaces 51 and 53 of dielectric body 52.

## Claims

1. Method of forming an aperture in a dielectric substrate and securing a conductive pin in said aperture comprising the steps of:

forming a unitized dielectric body (43) from a plurality of green sheet dielectric planar layers layed on an X—Y-plane and stacked in an orthogonal Z-direction, said body having two major opposite-surfaces (39, 41) orthogonal to the direction of said dielectric planar layers and extending in an X—Z-plane, and said body having a coefficient of shrinkage responsive to a heat treatment that is different along the direction of the Z-axis of said dielectric planar layers from that in the X—Y-plane of said planar layers thereby making said major surfaces to have different coefficiencts of shrinkage along the two orthogonal Z- and X-axes;

forming an aperture in said substrate through one of said major surfaces;

performing said heat treatment to thereby change irreversibly the shape of said aperture through a differential shrinkage along said two orthogonal Z- and X-axes;

inserting a deformable contact pin (29) in said aperture with one end tightly locked in said aperture and the opposite end protruding therefrom.

2. Method according to claim 1 characterized in that said aperture is formed on a predetermined portion (33; Fig. 5) of one of a plurality of conductor lines (34) formed on each of said dielectric planar layers thereby making said contact pin one of the exposed terminations of said conductor line.

3. Method according to claim 2 characterized in that it further includes providing a metal pad (24, 35, 47) on said exposed termination and around said contact pin (23, 29, 46).

4. Method according to claim 3 characterized in that said predetermined portion (33) of said conductor line (34), where said aperture is formed is provided with a flared portion (33) of a sufficient size to permit said aperture to be formed with split tabs of said conductor line on different edges of said aperture.

5. Method according to claim 1 characterized in that said aperture is formed adjacent a termination of a conductor line (49) and which further includes forming a pad (47) around said aperture and forming a solder fillet (48) electrically connecting said pad to said contact pin.

## Patentansprüche

1. Verfahren zum Vorsehen einer Öffnung in einem dielektrischen Substrat und Befestigen eines leitenden Stiftes in der Öffnung, folgende Schritte umfaßend:

Herstellen eines einheitlichen dielektrischen Körpers (43) aus mehreren ungebrannten dielektrischen ebenen Schichten, die auf einer XY-Ebene vorgesehen und in orthogonaler Z-Richtung gestapelt sind, wobei dieser Körper zwei sich gegenüberliegende Hauptflächen (39, 41) aufweist, die orthogonal zur Richtung der dielektrischen ebenen Schichten vorgesehen sind und sich in einer XZ-Ebene erstrecken, sowie einen auf eine Wärmebehandlung ansprechenden Schrumpfkoeffizienten, welcher sich entlang der Richtung der Z-Achse der dielektrischen ebenen Schichten von demjenigen in der XY-Ebene der ebenen Schichten unterscheidet, sodaß die Hauptflächen unterschiedliche Schrumpfkoeffizienten entlang der zwei orthogonalen Z- und X-Achsen haben;

Vorsehen einer Öffnung im Substrat durch eine der Hauptflächen;

Ausführen der Wärmebehandlung, um dadurch die Form der Öffnung durch unterschiedliche Schrumpfung entlang der zwei orthogonalen Z- und X-Achsen bleibend zu verändern;

Einführen eines verformbaren Kontaktstifts (29) in die Öffnung, wobei ein Ende in derselben fest eingeklemmt wird und das andere aus ihr herausragt.

2. Verfahren nach Anspruch 1, dadurch gekennzeichnet, daß die Öffnung auf einem vorbestimmten Abschnitt (33; Fig. 5) einer von mehreren auf den dielektrischen ebenen Schichten angeordneten Leitungen (34) vorgesehen ist, sodaß der Kontaktstift einer der freiliegenden Endpunkte der Leitung ist.

3. Verfahren nach Anspruch 2, dadurch gekennzeichnet, daß außerdem eine metallische Kontaktfläche (24, 35, 47) auf dem freiliegenden Endpunkt und um den Kontaktstift (23, 29, 46) vorgesehen ist.

4. Verfahren nach Anspruch 3, dadurch gekennzeichnet, daß der die Öffnung tragende vorbestimmte Abschnitt (33) der Leitung (34) einen sich erweiternden Abschnitt (33) aufweist, der groß genug ist, um die Öffnung mit aufgeteilten Kontaktflächen der Leitung auf verschiedenen Kanten der Öffnung herstellen zu können.

5. Verfahren nach Anspruch 1, dadurch gekennzeichnet, daß die Öffnung neben einem Endpunkt einer Leitung (49) vorgesehen wird, und daß eine Kontaktfläche (47) um die Öffnung vorgesehen und eine Lötkehle (48) angebracht wird, welche die Kontaktfläche elektrisch mit dem Kontaktstift verbindet.

## Revendications

1. Procédé pour ménager une ouverture dans un substrat diélectrique et pour fixer une broche conductrice dans ladite ouverture, comportant les opérations suivantes:

formation d'un corps diélectrique unifié (43) à partir d'une pluralité de couches planes de diélectrique en feuilles crues, disposées sur un plan X—Y et empilées dans une direction orthogonale Z, ledit corps ayant deux grandes surfaces opposées (39, 41) perpendiculaires à la direction desdites couches planes en diélectrique et s'étendant dans un plan X—Z, et ledit corps ayant un coefficient de retrait en réponse à un traitement thermique qui n'est pas le même dans le sens de l'axe Z desdites couches planes de diélectrique et dans le plan X—Y desdites couches planes, ce qui fait que lesdites grandes surfaces ont des coefficients de retrait différents sur les deux axes orthogonaux Z et X;

formation d'une ouverture dans ledit substrat à travers une desdites grandes surfaces;

réalisation dudit traitement thermique afin de modifier de façon irréversible par celui-ci la forme de ladite ouverture, par l'intermédiaire d'un retrait différentiel sur lesdits deux axes orthogonaux Z et X;

insertion d'une broche de contact déformable (29) dans ladite ouverture, une extrémité étant fermement verrouillée dans ladite ouverture et l'extrémité opposée dépassant de celle-ci.

2. Procédé selon la revendication 1, caractérisé en ce que ladite ouverture est formée sur une portion prédéterminée (33; Fig. 5) d'une ligne parmi une pluralité de lignes conductrices (34) formées sur chacune desdites couches planes en diélectrique en faisant de ce fait de ladite broche de contact une des terminaisons découvertes de ladite ligne conductrice.

3. Procédé selon la revendication 2, caractérisé en ce qu'il comporte en outre la réalisation d'un plot métallique (24, 35, 47) sur ladite terminaison découverte et autour de ladite broche de contact (23, 29, 46).

4. Procédé selon la revendication 3, caractérisé en ce que ladite portion prédéterminée (33) de la ligne conductrice (34), où est ménagée ladite l'ouverture, est pourvue d'une partie évasée (33) de dimensions suffisantes pour permettre à l'ouverture d'être dotée de languettes d'éclatement de ladite ligne conductrice sur des bords différents de ladite ouverture.

5. Procédé selon la revendication 1, caractérisé en ce que ladite ouverture est ménagée de façon contiguë à une terminaison d'une ligne conductrice (49), et comportant en outre la formation d'un plot (47) autour de ladite ouverture et la formation d'un cordon de soudure (48) assurant la connexion électrique entre ledit plot et ladite broche de contact.

FIG. 1
(PRIOR ART)

FIG. 2a

FIG. 2b

FIG. 3a

FIG. 3b

FIG.4a

FIG.4b

FIG.4c

**FIG.5**

**FIG.6**

**FIG.7**